# EUROPÄISCHE PATENTSCHRIFT

(11) **EP 1 371 620 B1**
(45) Veröffentlichungstag und Bekanntmachung des Hinweises auf die Patenterteilung: **14.12.2005**
(21) Anmeldenummer: 03012702.1
(22) Anmeldetag: 04.06.2003
(51) Int. Cl.: H01L 21/316, C23C 18/12

(54) **Verfahren zum Aufschleuder-Beschichten mit einem Sol-Gel-Verfahren**
Method for spin coating including sol-gel processing
Procédé de revêtement par centrifugation par voie sol-gel

(30) Priorität: 11.06.2002 DE 10225972
(43) Veröffentlichungstag der Anmeldung: 17.12.2003
(73) Patentinhaber: Fachhochschule Kiel, 24149 Kiel (DE)
(72) Erfinder: Es-Souni, Mohammed, Prof. Dr., 24247 Mielkendorf (DE); Piorra, André, 24118 Kiel (DE)
(74) Vertreter: Biehl, Christian

(56) Entgegenhaltungen:
- US-A- 5 585 136
- US-A- 5 626 923

## Beschreibung

Die Erfindung betrifft ein Verfahren zum Erzeugen einer dicken Keramikschicht mit einem Sol-Gel-Verfahren nach dem Oberbegriff des Hauptanspruches.

Keramische Beschichtungen aus Oxid- und Nichtoxidkeramiken werden heute u.a. bei der Fertigung piezoelektrischer Bauelemente vorgenommen, wie sie etwa in Druck- und Beschleunigungssensoren oder in Mikromotoren zum Einsatz kommen. Insbesondere pyroelektrische Keramiken lassen sich in komplexerer Zusammensetzung als wärmesensitive Schichten anordnen (z.B. flächiger Infrarotdetektor) und ferroelektrische Schichten eignen sich u.a. zum Aufbau von hochkapazitiven Kondensatoren mit elektrisch beeinflußbarem Dielektrikum.

Typische Materialien zur Bildung der Keramikschichten sind Metalloxide, wie beispielsweise Zirkondioxid ZrO₂, Titandioxid TiO₂, Bleizirkonattitanat Pb(ZrₓTi₁₋ₓ)O₃ (PZT) oder Bariumstrontiumtitanat Ba(SrₓTi₁₋ₓ)O₃ (BST) mit 0<x<1 für verschiedene stöchiometrische Zusammensetzungen.

Der Stand der Technik kennt verschiedene Verfahren zur Herstellung keramischer Schichten, von denen eines als Sol-Gel-Verfahren bezeichnet wird. Dabei werden zuerst die metallischen Komponenten des späteren Metalloxid-Überzugs als organische Moleküle (typisch: Metallalkoholat, Metallsalze) in einem geeigneten Lösungsmittel (zum Beispiel Essigsäure, oder Methoxyethanol oder einem Gemisch aus diesen) in den gewünschten Massenverhältnissen vermischt. In einem solchen, als Sol bezeichneten Gemisch können die Metallalkoholate durch Zugabe von Wasser hydrolysiert werden.

Damit die Metalle nicht aus der Lösung ausfallen, ist das Sol zuerst zu stabilisieren, z.B. durch Zugabe von Acetylaceton, Essigsäure oder Diethanolamin. Die teilweise hydrolysierten Alkoholate können langkettige Makromoleküle (Polymerisation) bilden, und bei Entzug des Lösungsmittels bildet sich ein organisches Gel, in dem alle Teilchen miteinander verbunden sind (hohe Viskosität).

Das Aufbringen der keramischen Schichten erfolgt dann durch Aufschleudern oder Aufsprühen des Gels auf z.B. hochreine Substrate (z.B. platiniertes Silizium, Aluminiumoxyd, Lanthanaluminat (LaAlO₃), Glas, Metallsubstrate). Das aufgebrachte Material wird anschließend zur Entfernung des Lösungsmittels erhitzt (mehrere 100°C) und in vielen Fällen bei Temperaturen bis 1000°C noch gesintert, um möglichst gleichmäßige Schichten zu erzielen.

Der Hauptnachteil des konventionellen Sol-Gel-Prozesses besteht darin, daß sich rißfreie Schichten nur bei geringen Schichtdicken von bis zu 1 µm erreichen lassen. Um eine gleichmäßig dicke, rißfreie Schicht von 10 µm und mehr zu erzielen, wäre das vielmalige Wiederholen des gängigen Verfahrens erforderlich, was natürlich entsprechend teuer ist.

Der Fachmann kennt weiterhin aus US 5,585,136 und US Re. 36,573 ein modifiziertes Sol-Gel-Verfahren, das in der Fachliteratur auch als Hybrid-Sol-Gel-Verfahren bezeichnet wird. Dabei wird dem herkömmlich gemischten Sol ein feines Keramikpulver beigemengt, beispielsweise polykristallines PZT (Blei-Zirkonat-Titanat) mit definierter Stöchiometrie, wie es heute auch im Handel erhältlich ist.

Mit Hilfe der Hybrid-Sol-Gel-Methode ist es möglich, mehrere Mikrometer dicke Keramikschichten in einem einzigen Arbeitsgang auf das Substrat aufzutragen. Allerdings sind diese nach dem Stand der Technik gefertigten Schichten gemeinhin nicht frei von Brüchen und Rissen und besitzen keine gleichmäßige Dicke.

Die Aufgabe der Erfindung besteht nun in der einfachen Herstellung einer gleichmäßigen, dicken (z.B. bis zu 3 µm), rißfreien Keramikschicht, wobei die Keramik aus einer Vielfalt von Materialien wählbar sein soll, und einfach - in möglichst einem einzigen Arbeitsgang - aufgebracht werden soll.

Diese Aufgabe wird durch das Verfahren des Anspruchs 1 gelöst. Die Unteranspüche geben vorteilhafte Schritte zur Senkung der Temperaturen, Anpassung an die Materialien und Vereinfachung des Verfahrens an.

Insbesondere ist vorteilhaft daß bei dem Verfahren zum Erzeugen einer dicken Keramikschicht mit einem Sol-Gel-Verfahren, niedrigschmelzendes Sinterglas verwendet wird, das dem mit einem Lösungsmittel versetzten Sol zusätzlich zu dem Keramikpulver homogen beigegeben wird, woraufhin das Sol durch Lösungsmittelentzug nach Auftrag auf das Substrat zu einer Schicht mit Gelstruktur gewandelt wird, und durch Pyrolyse des Gels die Keramikschicht erzeugt wird.

Dabei kann das Glaspulver zusätzlich, oder bevorzugt anstelle eines Teils (insbesondere bis zu 8%) der Menge des üblicherweise zugesetzten Keramikpulvers zugesetzt werden.

Das Sol sollte insbesondere durch Aufschleuderbeschichten (spin-coating) in den Porenraum einer bereits erzeugten Matrix einer vorhandenen Schicht eingebracht werden. Vorteilhaft, aber nicht notwendig ist es, diesen Porenraum ebenfalls mit dem erfindungsgemäß angereicherten Sol zu erstellen.

Beim Infiltrieren der Porenraum-Matrix wird dann eine fünf bis zehnfach höhere Aufschleuderdrehzahl Verwendung finden als beim Aufbringen der Porenraumschicht. Das Lösungsmittel sollte dabei insbesondere zur besseren Ausbildung der Schicht durch schnelles Aufheizen auf über 500°C in weniger als 45 min. entfernt werden und es ist auch wesentlich, daß das Sol nach Zugabe des Glases homogenisiert und gesiebt wird.

Weitere Vorteile und Merkmale der Erfindung werden in den nachfolgenden Beispielen erläutert. Dabei zeigt :

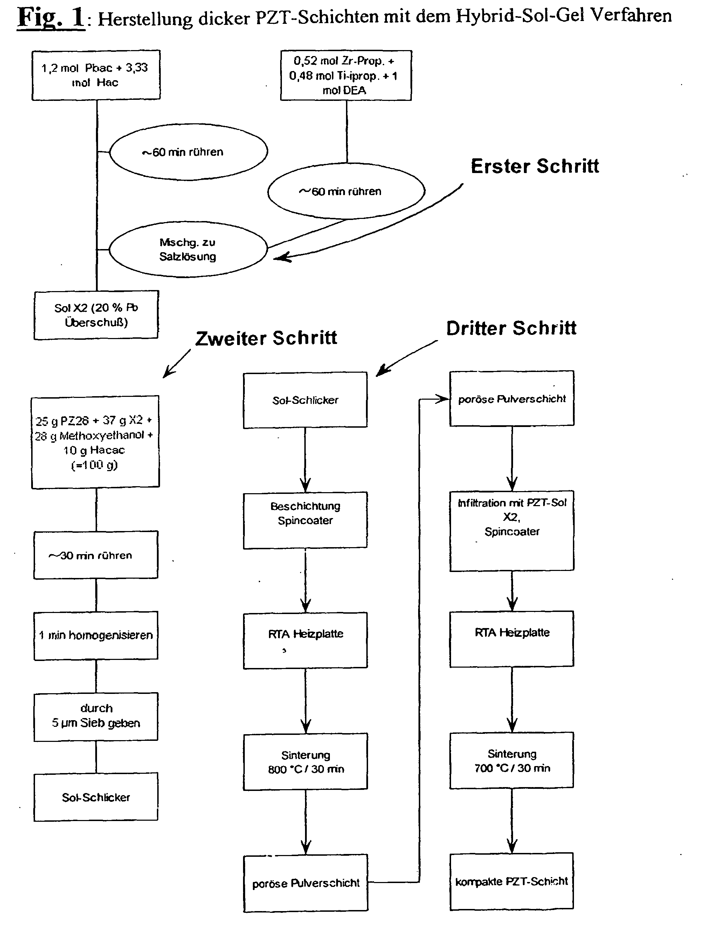

- Fig. 1: schematisch ein Beispiel des Ablaufs des bekannten Hybrid-Sol-Gel-Verfahrens.

### Beispiel 1:

Beispielsweise kann das erfindungsgemäße Vorgehen dabei im einzelnen aus den folgenden Schritten bestehen :
1. Anmischen eines Sols, vorzugsweise durch das Lösen von Metallalkoholaten oder Metallsalzen in geeigneten Lösungsmitteln wie Methoxyethanol, Essigsäure oder Diethanolamin oder in einem Gemisch verschiedener Lösungsmittel. Die Massenanteile der beteiligten Metallalkoholate und Metallsalze können dabei in weiten Bereichen frei gewählt werden und legen so die stöchiometrische Zusammensetzung, und damit auch die physikalischen Eigenschaften der letztendlich hergestellten Keramikschicht fest.
2. Stabilisieren des Sols, z.B. durch Zugabe von Acetylaceton oder Essigsäure, um das Ausfallen der Metalle bei der anschließenden Hydrolyse zu verhindern.
3. Zugabe von Keramikpulver, vorzugsweise derselben Keramik, die auch durch den Sol-Gel-Prozeß gebildet wird, vorzugsweise mit der beabsichtigten Stöchiometrie.
4. Zugabe von Sinterglas zur Unterstützung des späteren Sintervorgangs. Bevorzugt wird hier niedrig schmelzendes Sinterglas. Doch auch die Verwendung gewöhnlichen Fensterglases ist möglich, wenn eine entsprechend hohe Sintertemperatur vorgegeben werden soll. - In einer bevorzugten Ausführung dieses Verfahrensschritts wird ein Massenanteil von 0-8 % des Keramikpulvers durch die entsprechende Masse Sinterglas ersetzt.
5. Homogenisieren und Sieben des Sol-Keramikpulver-Sinterglas-Gemisches.
6. Aufschleudern auf das Substrat mit einer gängigen Aufschleudervorrichtung (Spincoating).
7. Polymerisation zum Gel durch Hydrolyse,
8. Entfernen des Lösungsmittels (Trocknen) durch schnelles Aufheizen auf einer Temperatur von 550 °C und für die Dauer von 30 min (Rapid Thermal Annealing, RTA).
9. Sinterung im Ofen bei Temperaturen bis zu 1000 °C für die Dauer von 30 min. Nach dem Sintern besteht auf dem Substrat eine mehrere µm dicke, poröse Pulverschicht, die noch nicht die gewünschten Qualitätsmerkmale besitzt.
10. Infiltrieren der Pulverschicht mit dem unter 1. gemischten Sol, wobei das Sol zunächst in ähnlicher Weise wie unter 7. auf die Pulverschicht aufgeschleudert wird und danach durch Erhöhung der Drehzahl, typisch um einen Faktor 5-10, in den Porenraum der Pulverschicht hinein gedrückt wird.
11. Entfernen des Lösungsmittels analog zu 8.
12. Erneute Sinterung im Ofen bei Temperaturen bis zu 1000 °C für die Dauer von 30 min.

### Beispiel 2

Die erfindungsgemäße Erweiterung des bekannten Hybrid-Sol-Gel-Verfahren besteht im der Zugabe von gemahlenem Glas vor der Pyrolyse zur Unterstützung des Sintervorgangs in Schritt 5.

Eine Einschränkung an Stöchiometrie und physikalische Eigenschaften der letztlich erzielten kompakten Keramikschicht besteht durch diese Modifikation nicht, da sich die Keramikpulver in fast jeder Variation herstellen bzw. erwerben lassen und eine zusätzliche Feinabstimmung durch die präzise Wahl der Zusammensetzung des Sols bei der Infiltration obendrein möglich ist.

Eine weiterführende Abwandlung des hier beschriebenen Verfahrens besteht in der Möglichkeit, in den Porenraum einer beliebigen porösen Pulverschicht (Matrix) ein Sol einer beliebigen anderen Keramik einzubringen und so durch die Infiltrationsmethode Keramikschichten sehr komplexer Zusammensetzung zu erhalten, die sich mit dem nach dem Stand der Technik bekannten Sol-Gel-Prozeß nicht erzeugen lassen.

### verwendete Abkürzungen :

- PbAc :: Bleiacetat-trihydrat
- Ac :: Essigsäure
- Zr-Prop:: Zirkonium-propoxid
- Ti-iprop:: Titanium-isopropoxid
- DEA :: Diethanolamin
- Hacac :: Acetylaceton
- PZ21 und PZ28:: Kommerzielle PZT-Pulver (Hier kann ebenfalls ein Barium-Strontium-Titanat-Pulver, ein TiO2 oder ZrO2 pulver verwendet werden.
- RTA :: Rapid Thermal Annealing: Schnelles Aufheizen auf Endtemperatur
- Ultrathurax:: Homogenisierungsgerät. Es kann ein alternatives Homogenisierungsgerät eingesetzt werden.
- Glas :: kommerzielles Glaspulver mit Schmelztemperatur um 500-600 °C.

## Patentansprüche

1. Verfahren zum Erzeugen einer dicken Keramikschicht mit einem Sol-Gel-Verfahren, wobei
- dem mit Lösungsmittel versetzten Sol ein Keramikpulver homogen beigegeben wird,
- durch Lösungsmittelentzug das Sol nach Auftrag auf das Substrat zu einer Schicht mit Gelstruktur gewandelt wird, und
- durch Pyrolyse des Gels die Keramikschicht erzeugt wird,
**gekennzeichnet durch**
die Zugabe von gemahlenem Glas vor der Pyrolyse.

2. Verfahren nach Anspruch 1, **dadurch gekennzeichnet, daß** das Glas niedrigschmelzendes Sinterglas ist.

3. Verfahren nach einem der vorangehenden Ansprüche, **dadurch gekennzeichnet, daß** anstelle eines Teib des Keramikpulvers Glaspulver zugesetzt wird.

4. Verfahren nach einem Anspruch 3, **dadurch gekennzeichnet, daß** für die beigegeben Glasmasse auf bis zu 8% der Keramikpulvermasse verzichtet wird.

5. Verfahren nach einem der vorangehenden Ansprüche, **dadurch gekennzeichnet, daß** das Sol durch Aufschleuderbeschichten (spin-coating) in den Porenraum einer bereits erzeugten Matrix einer vorhandenen Schicht eingebracht wird.

6. Verfahren nach einem der vorangehenden Ansprüche, **dadurch gekennzeichnet, daß** in einem ersten Auftrag eine zu sinternde Keramikschicht mit einem Porenraum aus dem gleichen Solgel erzeugt wird, das danach zum Infiltrieren der Porenraum-Matrix unter höherer Aufschleuderdrehzahl Verwendung findet.

7. Verfahren nach einem der vorangehenden Ansprüche, **dadurch gekennzeichnet, daß** das Lösungsmittel durch schnelles Aufheizen auf über 500°C in weniger als 45 min. entfernt wird.

8. Verfahren nach einem der vorangehenden Ansprüche, **dadurch gekennzeichnet, daß** das Sol nach Zugabe des Glases homogenisiert und gesiebt wird.

## Claims

1. Method for producing a thick ceramic coating using a sol-gel process, in which
- a ceramic powder is homogeneously added to the sol mixed with the solvent,
- by solvent extraction, after application to the substrate the sol is transformed into a coating with a gel structure and
- by gel pyrolysis the ceramic coating is produced,
**characterized by** the addition of crushed glass prior to pyrolysis.

2. Method according to claim 1, **characterized in that** the glass is low-melting sintered glass.

3. Method according to one of the preceding claims, **characterized in that** glass powder is added in place of part of the ceramic powder.

4. Method according to claim 3, **characterized in that** up to 8% of the ceramic powder is replaced by the added glass powder.

5. Method according to one of the preceding claims, **characterized in that** the sol is introduced by spin coating into the pore space of an already produced matrix of an existing coating.

6. Method according to one of the preceding claims, **characterized in that** in a first application a ceramic coating to be sintered is produced with a pore space from the same sol-gel as is subsequently used for infiltrating the pore space matrix with a higher spin coating speed.

7. Method according to one of the preceding claims **characterized in that** the solvent is removed by rapid heating to above 500°C in less than 45 min.

8. Method according to one of the preceding claims, **characterized in that** the sol is homogenized and screened after adding the glass.

## Revendications

1. Procédé de fabrication d'une couche de céramique épaisse à l'aide d'un procédé par voie sol-gel, dans lequel
- on ajoute de façon homogène au sol mélangé au solvant une poudre de céramique,
- on transforme le sol une fois déposé sur le substrat en une couche à la structure de type gel par extraction au solvant, et
- on produit la couche de céramique par pyrolyse du gel,
**caractérisé par** l'adjonction de verre broyé avant la pyrolyse.

2. Procédé selon la revendication 1, **caractérisé en ce que** le verre est un verre fritté à bas point de fusion.

3. Procédé selon l'une quelconque des revendications précédentes, **caractérisé en ce que** l'on ajoute de la poudre de verre à la place d'une partie de la poudre de céramique.

4. Procédé selon la revendication 3, **caractérisé en ce qu'**en contrepartie de la masse de verre ajoutée, on renonce à jusqu'à 8 % de la masse de poudre de céramique.

5. Procédé selon l'une quelconque des revendications précédentes, **caractérisé en ce que** le sol est déposé par centrifugation (spin-coating) dans le volume de pores d'une matrice fabriquée au préalable d'une couche existante.

6. Procédé selon l'une quelconque des revendications précédentes, **caractérisé en ce que** lors d'un premier dépôt une couche de céramique à fritter est fabriquée avec un volume de pores issu du même sol-gel, qui sera utilisé ultérieurement pour l'infiltration de la matrice de volumes de pores sous un régime de rotation de centrifugation plus rapide.

7. Procédé selon l'une quelconque des revendications précédentes, **caractérisé en ce que** le solvant est éliminé par réchauffement rapide à plus de 500 °C en moins de 45 minutes.

8. Procédé selon l'une quelconque des revendications précédentes, **caractérisé en ce que** le sol est homogénéisé et tamisé après adjonction du verre.
